# EUROPEAN PATENT APPLICATION

(11) **EP 2 498 297 A2**
(43) Date of publication of application: **12.09.2012**
(21) Application number: 12158615.0
(22) Date of filing: 08.03.2012
(51) Int. Cl.: H01L 31/0224, H01L 31/0392, H01L 31/042, H01L 31/05

(54) **Low voltage thin film photovoltaic module**

(30) Priority: 11.03.2011 US 201113046471
(71) Applicant: Auria Solar Co., Ltd., Tainan City (TW)
(72) Inventor: Tsai, Chin-Yao, Tainan City (TW); Peng, Yu-Chun, Tainan City (TW); Lin, Po-Han, Tainan City (TW); Lin, Yi-Kai, Tainan City (TW); Liao, Chen-Liang, Tainan City (TW); Chang, Chih-Hsiung, Tainan City (TW); Lin, Kun-Chih, Tainan City (TW)
(74) Representative: Viering, Jentschura & Partner

(57) **Abstract**

In one aspect of the present invention, a photovoltaic module includes a plurality of sub-modules. Each sub-module includes a plurality of photovoltaic cells spatially arranged as an array, each cell having first and second conductive layers sandwiching an active layer therebewteen. The cells in each sub-module are electrically connected to each other in series. Each sub-module further includes positive and negative electrodes formed on the second conductive layers of the first and last cells, respectively, in a respective sub-module. The positive electrode of each sub-module is electrically connected to each other and the negative electrode of each sub-module is electrically connected to each other such that the plurality of sub-modules is electrically connected in parallel. The plurality of sub-modules is spatially arranged next to each other as an array such that at least one sub-module is spatially separated from its immediately next sub-module by a gap.

## Description

### FIELD OF THE INVENTION

The present invention relates to a photovoltaic device, and more particularly to a thin film photovoltaic module having a plurality of sub-modules spatially arranged next to each other such that at least one sub-module is separated from its immediately next sub-module by a gap, and the plurality of sub-modules is electrically connected to each other in parallel, thereby lowering the operation voltage thereof.

### BACKGROUND OF THE INVENTION

A photovoltaic cell converts the energy of sunlight into electricity by the photovoltaic effect. Assemblies of photovoltaic cells are used to make photovoltaic modules or solar panels. Most currently available photovoltaic cells are made from bulk materials such as crystalline silicon or polycrystalline silicon. Photovoltaic cells can also be made of thin film layers deposited on a substrate. Thin film photovoltaic cells reduce the amount of material required thus reducing material cost compared to bulk photovoltaic cells. Thin film silicon cells are becoming increasingly popular due to their low cost, flexibility, light weight, and ease of integration.

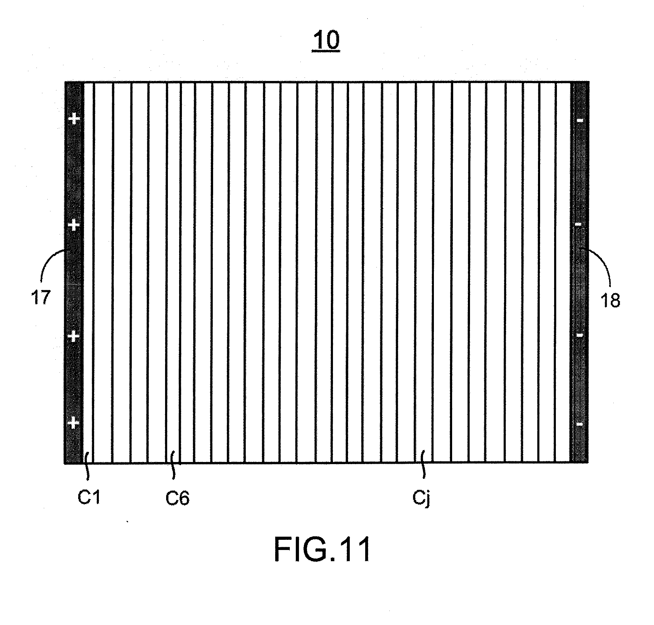

FIG. 11 shows a top view of a conventional thin film photovoltaic module 10. The thin film photovoltaic module 10 includes a plurality of photovoltaic cells, {Cj}, spatially arranged as an array, where j = 1, 2, 3, ... N, N being an positive integer. In this illustrative example, the plurality of photovoltaic cells {Cj} is formed on a substrate. Each photovoltaic cell Cj has a front conductive layer formed on the substrate, an active (photovoltaic) layer formed on the front conductive layer, and a back conductive layer formed on the active layer. The photovoltaic module 10 also has a positive electrode 17 formed on the back conductive layer of the first photovoltaic cell C1 and a negative electrode 18 formed on and the back conductive layer of the last photovoltaic cell CN. All photovoltaic cells C1-CN are connected in series. This configuration has the disadvantage that the operation voltage of the photovoltaic module 10 is relatively high compared to a bulk silicon photovoltaic module of the same size, which may result in higher installation cost due to higher inverter cost.

Therefore, a heretofore unaddressed need exists in the art to address the aforementioned deficiencies and inadequacies.

### SUMMARY OF THE INVENTION

The present invention, in one aspect, relates to a thin film photovoltaic module formed on a substrate. The substrate comprises glass, plastic, or metal. In one embodiment, the photovoltaic module includes a plurality of sub-modules.

Each of the sub-modules comprises a plurality of photovoltaic cells spatially arranged as an array, where each photovoltaic cell has a first conductive layer formed on the substrate, an active layer formed on the first conductive layer, and a second conductive layer formed on the active layer. The plurality of photovoltaic cells in each of the sub-modules are electrically connected to each other in series such that the second conductive layer in any one but the last cell in a respective sub-module is electrically connected to the first conductive layer of the immediate next cell in the respective sub-module. The active layer includes one or more light absorption layers formed of one or more semiconductors. In one embodiment, the active layer includes an amorphous silicon (a-Si) layer, a micro-crystalline silicon (µc-Si) layer, or both layers. In one embodiment, each of the first conductive layer and the second conductive layer comprises a transparent conducting oxide (TCO) or a metal. The TCO comprises, but is not limited to, zinc oxide (ZnO), tin oxide (SnO₂), indium tin oxide (ITO), aluminum tin oxide (ATO), aluminum zinc oxide (AZO), cadmium indium oxide (CIO), cadmium zinc oxide (CZO), gallium zinc oxide (GZO), fluorine tin oxide (FTO), or a combination of them. The metal comprises, but is not limited to, chromium (Cr), copper (Cu), molybdenum (Mo), titanium (Ti), nickel (Ni), aluminum (Al), gold (Au), or silver (Ag).

The sub-modules are spatially arranged next to each other and separated by a gap such that a pair of adjacent electrodes positioned at each side of the gap has the same polarity. In one embodiment, the gap has a width ranging from about 0.1 µm to about 1500 µm.

The pair of adjacent electrodes is electrically connected to each other. In one embodiment, the pair of adjacent electrodes is electrically connected to each other via a conductive member formed in and/or across over the gap. In one embodiment, the conductive member is formed of a material that has an electrical conductivity that is not lower than, preferably higher than, that of the second conductive layer.

Each sub-module further comprises a positive electrode and a negative electrode formed on the second conductive layer of the first cell and on the second conductive layer of the last cell, respectively, in a respective sub-module. The positive electrode of each sub-module is electrically connected to each other, and the negative electrode of each sub-module is electrically connected to each other, such that the plurality of sub-modules is electrically connected in parallel. In one embodiment, the positive electrode of each sub-module is electrically connected to each other by a first conductive ribbon, and wherein the negative electrode of each sub-module is electrically connected to each other by a second conductive ribbon.

The plurality of sub-modules is spatially arranged next to each other as an array in the same direction as the array of the plurality of cells in each sub-module such that each two adjacent sub-modules are separated by a gap therebetween. In one embodiment, each gap has a width ranging from about 0.1 µm to about 1500 µm.

In one embodiment, a corresponding pair of adjacent electrodes positioned at each side of the gap has the same polarity, and each pair of adjacent electrodes positioned at each side of the gap is electrically connected to each other via a conductive member formed in and/or across over the gap spatially separating the corresponding pair of adjacent sub-modules. In one embodiment, the conductive member is formed of a material that has an electrical conductivity that is not lower than that of the corresponding second conductive layer positioned at each side of the gap.

In another embodiment, at least one sub-module and its immediately next sub-module are configured such that at least one layer of the at least one sub-module is spatially separated from a corresponding layer of its immediately next sub-module.

These and other aspects of the present invention will become apparent from the following description of the preferred embodiment taken in conjunction with the following drawings, although variations and modifications therein may be effected without departing from the spirit and scope of the novel concepts of the disclosure.

### BRIEF DESCRIPTION OF THE DRAWINGS

The accompanying drawings illustrate one or more embodiments of the invention and together with the written description, serve to explain the principles of the invention. Wherever possible, the same reference numbers are used throughout the drawings to refer to the same or like elements of an embodiment, and wherein:

FIG. 1 shows schematically a top view of a thin film photovoltaic module according to one embodiment of the present invention;

FIG. 2 shows schematically a cross-sectional view of a thin film photovoltaic module according to one embodiment of the present invention;

FIG. 3 shows schematically a current flow in a photovoltaic module;

FIGS. 4A and 4B show schematically cross-sectional views of thin film photovoltaic modules according to two embodiments of the present invention;

FIGS. 5A-5F show schematically processes of fabricating a photovoltaic module;

FIGS. 6A-6E show schematically cross-sectional views of thin film photovoltaic modules according to various embodiments of the present invention;

FIGS. 7A-7E show schematically cross-sectional views of thin film photovoltaic modules according to various embodiments of the present invention;

FIG. 8 shows schematically a cross-sectional view of a thin film photovoltaic module according to one embodiment of the present invention;

FIG. 9 shows schematically a cross-sectional view of a thin film photovoltaic module according to another embodiment of the present invention;

FIG. 10 shows schematically a cross-sectional view of a thin film photovoltaic module according to yet another embodiment of the present invention; and

FIG. 11 shows schematically a top view, respectively, of a conventional thin film photovoltaic module.

### DETAILED DESCRIPTION OF THE INVENTION

The present invention will now be described more fully hereinafter with reference to the accompanying drawings, in which exemplary embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like reference numerals refer to like elements throughout.

It will be understood that when an element is referred to as being "on" another element, it can be directly on the other element or intervening elements may be present therebetween. In contrast, when an element is referred to as being "directly on" another element, there are no intervening elements present. As used herein, the term "and/or" includes any and all combinations of one or more of the associated listed items.

It will be understood that, although the terms first, second, third, etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," or "includes" and/or "including" or "has" and/or "having" when used herein, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom", "upper" or "top," and "front" or "back" may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower", can therefore, encompasses both an orientation of "lower" and "upper," depending of the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

As used herein, "around", "about" or "approximately" shall generally mean within 20 percent, preferably within 10 percent, and more preferably within 5 percent of a given value or range. Numerical quantities given herein are approximate, meaning that the term "around", "about" or "approximately" can be inferred if not expressly stated.

The term ""substrate", as used herein, refers to a thin layer of material such as silicon, silicon dioxide, aluminum oxide, sapphire, germanium, gallium arsenide (GaAs), an alloy of silicon and germanium, indium phosphide (InP), glass, plastic, metal, etc., upon which a semiconductor device, e.g. a photovoltaic cell is applied.

As used herein, the term "plurality" means a number greater than one.

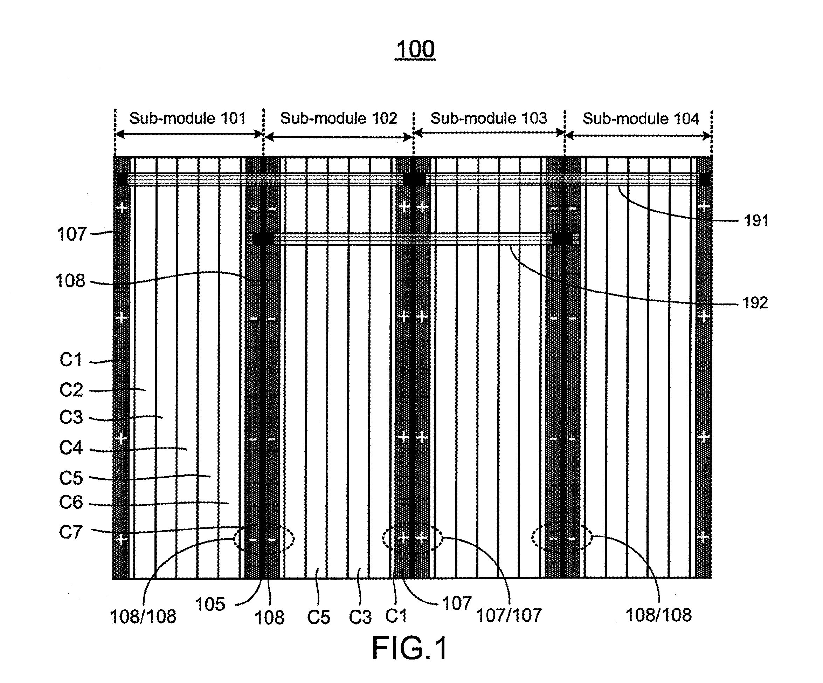

The description will be made as to the embodiments of the present invention in conjunction with the accompanying drawings in FIGS. 1-10. In accordance with the purposes of this invention, as embodied and broadly described herein, this invention, in one aspect, relates to a thin film photovoltaic module having low operation voltages.

FIG. 1 shows schematically a top view of a thin film photovoltaic module 100 according to one embodiment of the present invention. The photovoltaic module 100 includes a plurality of sub-modules, for example, four sub-modules 101, 102, 103 and 104. Other numbers of sub-modules can also be utilized to practice the present invention. Each sub-module 101, 102, 103 or 104 has a plurality of photovoltaic cells, {Cj}, spatially arranged one next another in an array, for example, along a horizontal direction, where j = 1, 2, 3, ... N, and N can be any number greater than one. In the exemplary embodiment shown in FIG. 1, a plurality of photovoltaic cells has seven (7) photovoltaic cells C1-C7. Each sub-module 101, 102, 103 or 104 also has a positive electrode 107 attached to the first photovoltaic cell C1 and a negative electrode 108 attached to the last photovoltaic cell C7. The sub-modules 101, 102, 103 and 104 are spatially arranged one next to another in an array along the horizontal direction, which is the same direction as the array of the photovoltaic cells C1-C7 of each sub-module 101, 102, 103 or 104. According to the present invention, each two adjacent sub-modules, for example, 101 and 102, 102 and 103, and 103 and 104, are separated by a spatial gap (or space) 105 therebetween and the pair of adjacent electrodes 107/107 or 108/108 positioned on each side of the gap 105 have the same polarity, indicated by "+" or "-", respectively. Each pair of adjacent electrodes is electrically connected to each other. In one embodiment, each pair of adjacent electrodes 107/107 or 108/108 is electrically connected to each other by a conductive member formed of a conductive material. The conductive member can be disposed in and/or across over the gap 105, and/or across over the gap 105. The conductive member can be a conductive bar, a conductive lead, a conductive bus, a conductive ribbon/strip, or other conductive means. The conductive member can be integrally formed with the pair of adjacent electrodes 107/107 or 108/108. Alternatively, the conductive member can be an individually formed member electrically connected to the pair of adjacent electrodes 107/107 or 108/108. Further, the positive electrode 107 of each of the plurality of sub-modules 101, 102, 103 and 104 is electrically connected to each other, for example, by a first electrically conductive ribbon 191, while the negative electrode 108 of each of the plurality of sub-modules 101, 102, 103 and 104 is electrically connected to each other, for example, by a second electrically conductive ribbon 192. In this fashion, the plurality of sub-modules 101, 102, 103 and 104 is electrically connected to each other in parallel. Accordingly, such a photovoltaic module 100 can have a low operation voltage that is comparable to that of a bulk silicon photovoltaic module of the same size. Further, it has advantages in installation over the conventional thin film solar modules.

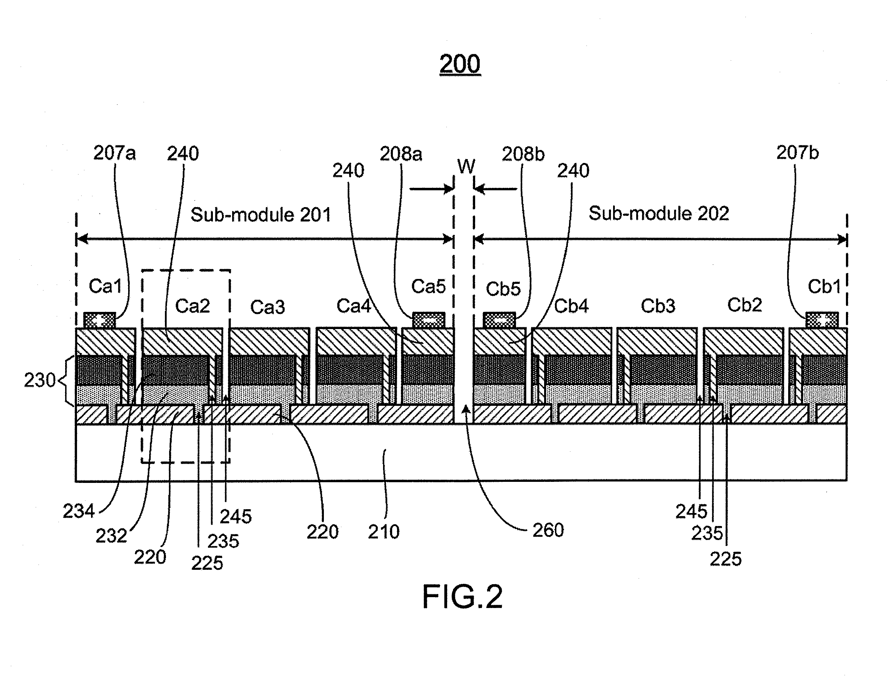

FIG. 2 shows schematically a cross sectional view of a thin film photovoltaic module 200 according to one embodiment of the present invention. In this illustrative example, the photovoltaic module 200 has a first sub-module 201 and a second sub-module 202 formed on a substrate 202. Each of the first sub-module 201 and the second sub-module 202 has five photovoltaic cells, which are indicated by Ca1-Ca5 and Cb1-Cb5, respectively. It should be appreciated to those of skill in the art that other numbers of sub-modules and photovoltaic cells can also be utilized to practice the present invention without departing from the spirit and intended scope of the invention.

Each of photovoltaic cells Cal-Ca5 and Cb1-Cb5 has a front (first) conductive layer 220 formed on the substrate 210, a back (second) conductive layer 240 and a photovoltaic (active) layer 230 sandwiched between the front conductive layer 220 and the back conductive layer 240. In one embodiment shown in FIG. 2, the active layer 230 includes a stacked structure of tandem junction. The stacked structure has, for example, a layer of amorphous silicon (a-Si) 232 formed on the front conductive layer 220 and a layer of micro-crystalline silicon (µc-Si) 234 formed on the a-Si layer 232, thereby defining an a-Si/µc-Si tandem junction. In another embodiment, the stacked structure may have a layer of n-doped Cds 232 formed on the front conductive layer 220 and a layer of p-doped CdTe 234 formed on the n-doped Cds layer 232, thereby defining an n:Cds/p:CdTs tandem junction.

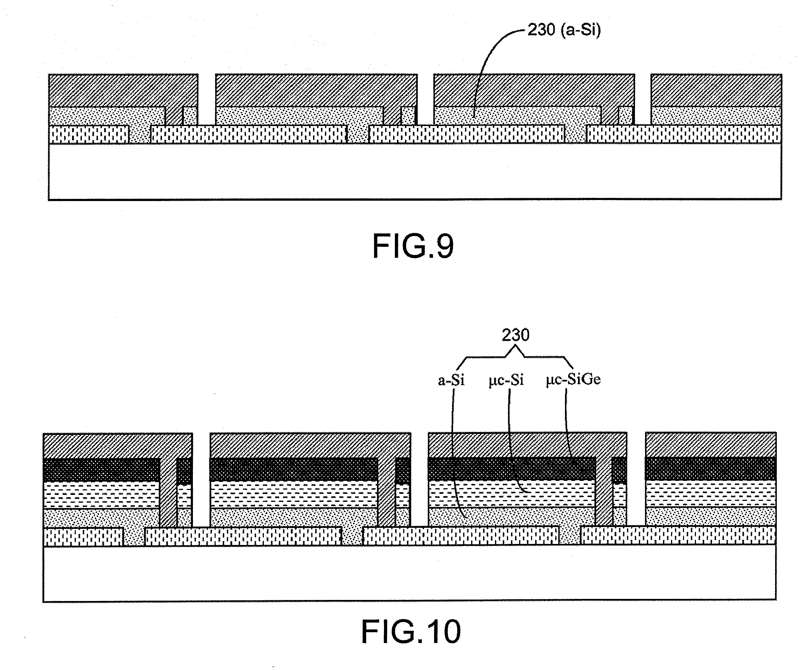

In other embodiments, the photovoltaic layer 230 can be a semiconductor thin film in Group IV elements of the Periodic Table, Group III-V compound semiconductor thin film, Group II-VI compound semiconductor thin film, organic semiconductor thin film or compound thereof. In details, the semiconductor thin film in Group IV elements of the Periodic Table is at least one of a carbon thin film, a silicon thin film, a germanium thin film, a silicon carbide thin film and a silicon germanium thin film, each of which may be in monocrystalline form, polycrystalline form, amorphous form or microcrystalline form, or a combination thereof. For example, the compound semiconductor thin film in Group III-V of the Periodic Table is at least one of gallium arsenide (GaAs) thin film and indium gallium phosphide (InGaP) thin film, or a combination thereof. The compound semiconductor thin film in Group II-VI, for example, includes at least one of a copper indium diselenide (CIS) thin film, a copper indium gallium diselenide (CIGS) thin film and a cadmium telluride (CdTe) thin film, or a combination thereof. Furthermore, the above mentioned organic compound semiconductor thin film can be a mixture of a conjugated polymer donor and PCBM acceptor. In addition, the film structure of the above mentioned photovoltaic layer 230 can be a PN single layer of photoelectric conversion structure, as shown in FIG. 9, composed of P-type semiconductor and N-type semiconductor or a PIN single layer of photoelectric conversion structure composed of P-type semiconductor, intrinsic layer and N-type semiconductor. However, the present invention is not limited thereto. In another embodiment, the film structure of the photovoltaic layer 230 can be a stacked structure of a tandem junction such as the a-Si/µc-S tandem junction or the n:Cds/p:CdTs tandem junction, a triple junction shown in FIG. 10, or more than three-layers of photoelectric conversion film structure. For example, the stacked structure of the triple junction shown in FIG. 10 can be an a-Si/µc-Si/µc-SiGe triple junction or i-ZnO/n:Cds/p:CIGS triple junction.

The substrate 210 is formed of a material of glass, plastic, or metal. The front conductive layer 220 and the back conductive layer 240 can be formed of the same material or substantially different materials. In one embodiment, each of the front conductive layer 220 and the back conductive layer 240 is formed of TCO, such as ZnO, SnO₂, ITO, ATO, AZO, CIO, CZO, GZO, FTO, or a combination of them. In another embodiment, the front conductive layer 220 and the back conductive layer 240 may be formed of a metal, such as Mo, Ti, Ni, Al, Au, Cr or Ag. Other TCO and metals can also be utilized to practice the present invention. According to the present invention, sunlight can be incident onto the photovoltaic cells at either the back conductive layer 240 or the substrate 210. If sunlight is incident onto the photovoltaic cells at the back conductive layer 240, the back conductive layer 240 is formed a transparently conductive material. Otherwise, if sunlight is incident onto the photovoltaic cells at the substrate 210, the substrate 210 is formed of a transparent material such as glass, and the front conductive layer 220 is formed of a transparently conductive material. The former is sometimes referred to "substrate-type photovoltaic cells", while the latter is sometimes referred to "superstrate-type photovoltaic cells".

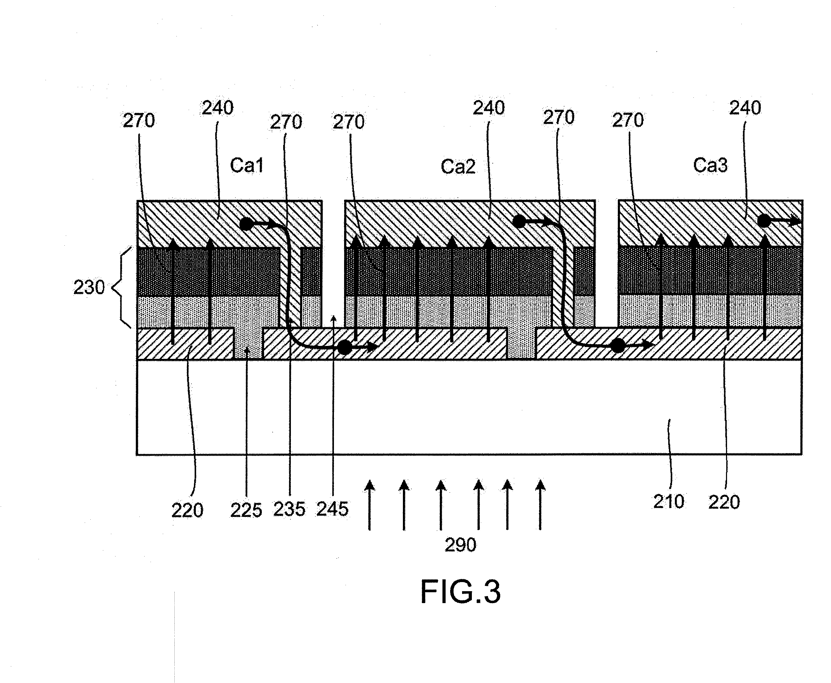

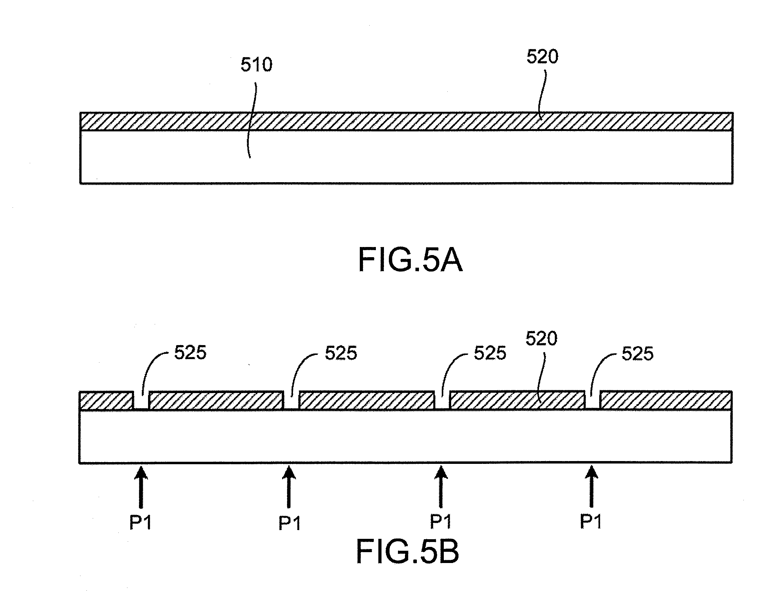

All the photovoltaic cells in each sub-module are electrically connected in series such that the second conductive layer 240 of any one but the last photovoltaic cell is electrically connected to the first conductive layer 220 of the immediate next photovoltaic cell. For example, for the first sub-module 201, the back conductive layer 240 of the first photovoltaic cell Ca1 is electrically connected to the front conductive layer 220 of the second photovoltaic cell Ca2 through a groove or opening 235, which is formed by the laser scribing process, as shown below in FIGS. 5A-5E. The back conductive layer 240 of the second photovoltaic cell Ca2 is electrically connected to the front conductive layer 220 of the third photovoltaic cell Ca3 through the groove or opening 235, and so on. It is same for the second sub-module 202. In operation, sunlight 290 shines on the photovoltaic module 200 either from the substrate 210 side or from the second (back) conductive layer 240 side and is absorbed by the active layer 230. In the illustrative example shown in FIG. 3, the sunlight 290 is incident onto the photovoltaic cells from the substrate 210 side. Through the photovoltaic effect, the active layer 230 converts the photon energy of the sunlight 290 into electric current 270 which flows from the first (front) conductive layer 220 to the second (back) conductive layer 240 in each photovoltaic cell. The electric current 270 in turn, flows from the second (back) conductive layer 240 of any one but the last photovoltaic cell to the first (front) conductive layer 220 of the immediate next photovoltaic cell through the groove 235.

Still referring to FIG. 2, the first sub-module 201 has an electrode 207a with a positive polarity formed on the back (second) conductive layer 240 of the first photovoltaic cell Ca1, and an electrode 208a with a negative polarity formed on the back (second) conductive layer 240 of the fifth (last) photovoltaic cell Ca5, respectively. Similarly, the second sub-module 202 has an electrode 207b with a positive polarity and an electrode 208b with a negative polarity formed on the back (second) conductive layer 240 of the first photovoltaic cell Cb1 and the back (second) conductive layer 240 of the fifth (last) photovoltaic cell Cb5, respectively. Each of the positive electrodes 207a/207b and the negative electrodes 208a/208b may be made of a metal such as Ag, Au, Al, Cr, Cu, Ni, Ti, or the like.

According to the present invention, the first sub-module 201 and the second sub-module 202 are spatially arranged next to each other and separated by a spatial gap (or space) 260. In one embodiment, the gap 260 has a width, W, ranging from about 0.1 µm to about 1500 µm. The first sub-module 201 and the second sub-module 202 are fabricated such that the second sub-module 202 is a mirror image of the first sub-module 201, and the two adjacent electrodes, for example, electrodes 208a and 208b, positioned on each side of the gap 260 have the same polarity. In this illustrative example shown in FIG. 2, the adjacent electrodes are negative electrodes 208a and 208b. The two adjacent electrodes 208a and 208b are electrically connected to each other by an additional material (not shown) that has an electrical conductivity that is not lower than, preferably higher than, that of the second conductive layers 240 of the photovoltaic cells Ca5 and Cb5.

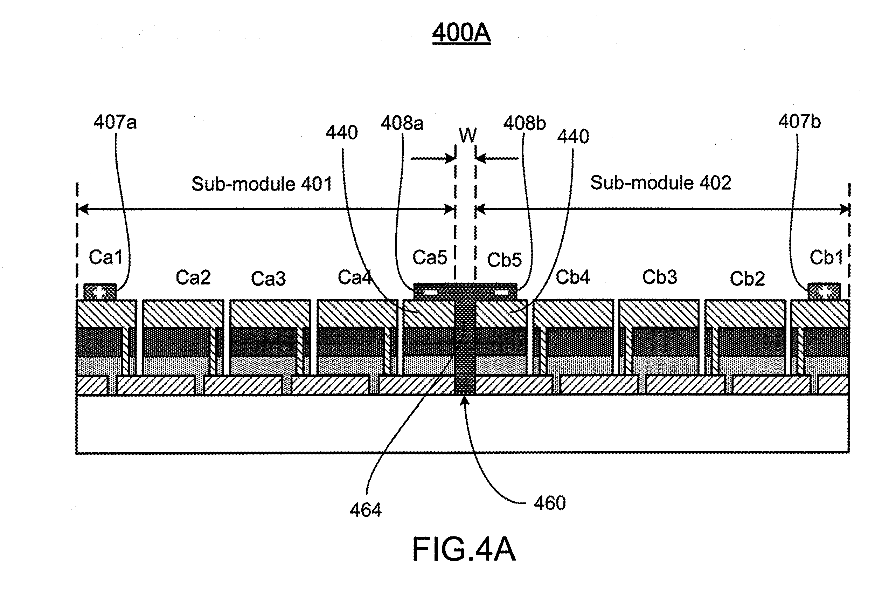

FIG. 4A shows schematically a cross sectional view of a thin film photovoltaic module 400A according to one embodiment of the present invention. The photovoltaic module 400A is similar to the photovoltaic module 200 shown in FIG. 2 except that the two adjacent electrodes 408a and 408b are electrically connected to each other via a conductive member 464 disposed over the gap 460 that spatially separates the first sub-module 401 and the second sub-module 402. The conductive member 464 is in substantially contact with or overlaps the two adjacent electrodes 408a and 408b. The conductive member 464 can be a conductive bar, a conductive lead, a conductive bus, a conductive ribbon/strip, or other conductive means. The conductive member 464 can be integrally formed with the pair of adjacent electrodes 408a and 408b. Alternatively, the conductive member 464 can be an individually formed member electrically connected to with the pair of adjacent electrodes 408a and 408b. The conductive member 464 is formed a material that is same as or substantially different from that of the two adjacent electrodes 408a and 408b. The material forming the conductive member 464 has an electrical conductivity that is not lower than, preferably higher than, that of the second conductive layer 440 of the photovoltaic cells Ca5 and Cb5, such as Ag, Au, Al, Cr, Cu, Ni, and Ti. In the exemplary embodiment shown in FIG. 4A, the conductive member 464 and the two adjacent electrodes 408a and 408b are integrally formed.

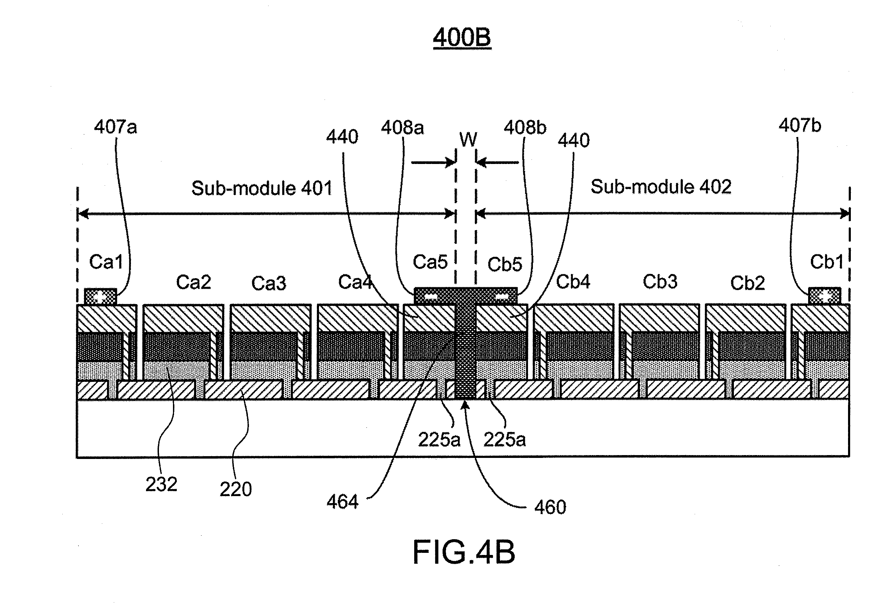

FIG. 4B shows schematically a cross sectional view of a thin film photovoltaic module 400B according to another embodiment of the present invention. The photovoltaic module 400B is similar to the photovoltaic module 400A shown in FIG. 4A, except that the two adjacent electrodes 408a and 408b are electrically connected to each other via a conductive member 464 formed in and/or across over the gap 460 spatially separating the first sub-module 401 and the second sub-module 402. In the exemplary embodiment shown in FIG. 4B, the front (first) conductive layers 220 of the photovoltaic cells Ca5 and Cb5 have an additional groove or opening 225a that are filled with the material of an active layer 232, such that the conductive member 464 formed in the spatial gap 460 is electrically and spatially isolated from the front (first) conductive layers 220 of the photovoltaic cells Ca5 and Cb5. Similarly, the conductive member 464 is formed a material that is same as or substantially different from that of the two adjacent electrodes 408a and 408b. The material forming the conductive member 464 has an electrical conductivity that is not lower than, preferably higher than, that of the second conductive layer 440 of the photovoltaic cells Ca5 and Cb5. In the exemplary embodiment, the conductive member 464 and the two adjacent electrodes 408a and 408b are integrally formed.

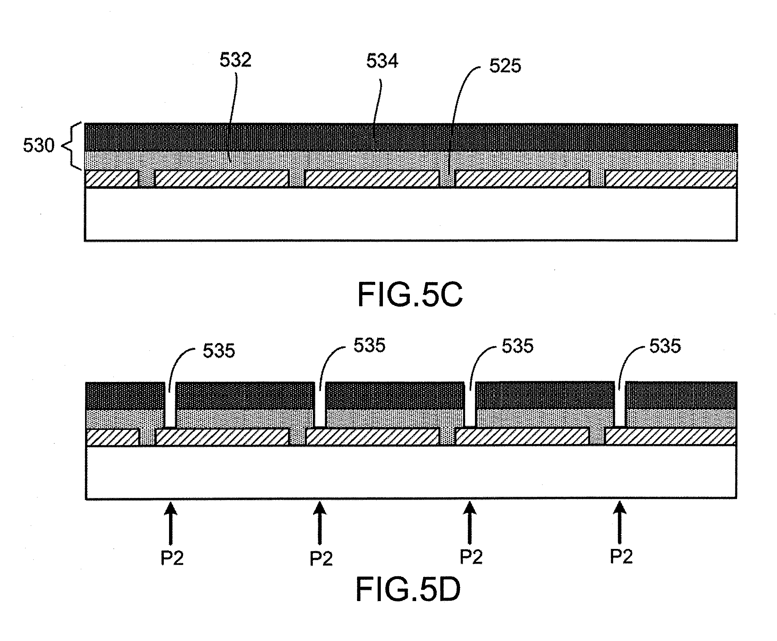

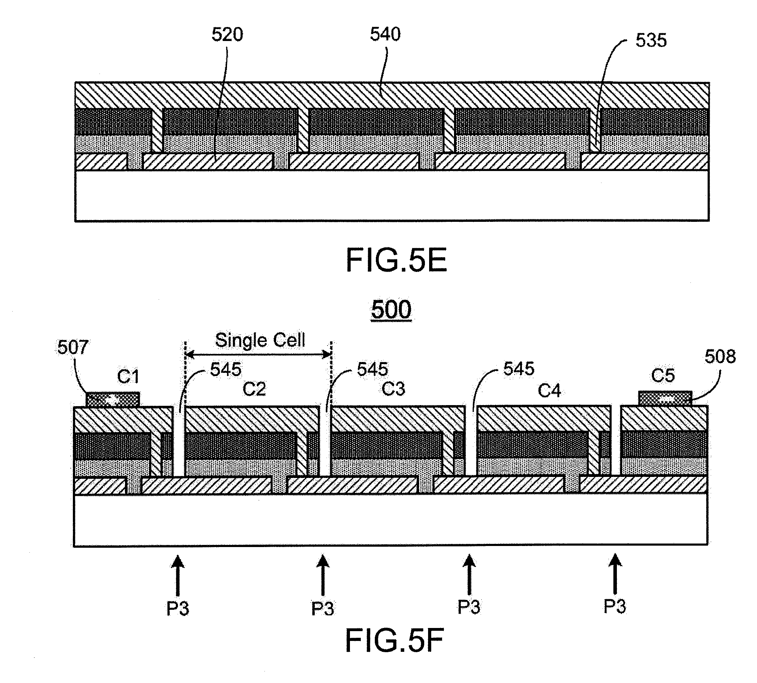

FIGS. 5A-5F show schematically processes of fabricating a photovoltaic module 500. At first, the first (front) conductive layer 520 is deposited on the substrate 510, as shown in FIG. 5A. Second, the first conductive layer 520 is scribed by a first laser scribing or mechanical needle scribing, P1, to create a plurality of first openings or grooves 525, thereby dividing the first conductive layer 520 into separate cells, as shown in FIG. 5B. Third, the active layer 530 is deposited on the first conductive layer 520, as shown in FIG. 5C. In one embodiment, the active layer 530 includes a layer of a-Si 532 formed on the front conductive layer 520 and a layer of uc-Si 534 formed on the a-Si layer 532. Fourth, the active layer 530 is scribed by a second laser scribing or mechanical needle scribing, P2, to create a plurality of second openings or grooves 535, as shown in FIG. 5D. Fifth, the second conductive layer 540 is deposited on the active layer 530, as shown in FIG. 5E. Sixth, the second (back) conductive layer 540 is scribed by a third laser scribing or mechanical needle scribing, P3, to create a plurality of third openings or grooves 545, as shown in FIG. 5F. Last, the positive electrode 507 and the negative electrode 508 are formed on the second conductive layer 540 of the first photovoltaic cell C1 and the second conductive layer 540 of the last photovoltaic cell C5, respectively.

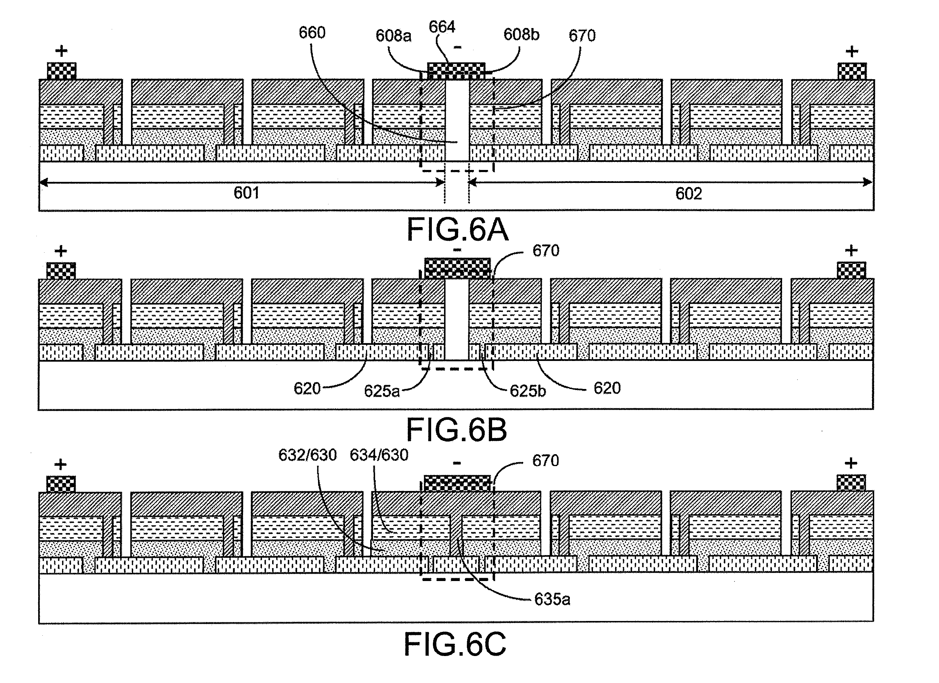

FIGS. 6A-6E show various connection configurations 670, corresponding to different gap definitions, between two adjacent sub-modules 601 and 602 according to different embodiments of the present invention. The pair of adjacent electrodes 608a and 608b formed on the two adjacent sub-modules 601 and 602 has the same negative polarity, indicated by "-", and is electrically connected to each other via a conductive member 664. As shown in FIG. 6A, the two adjacent sub-modules 601 and 602 are completely separated by a space or gap 660. In one embodiment, the gap 660 can be defined by the third laser scribing or mechanical needle scribing P3, as disclosed above and shown in FIG. 5F.

Further, an additional grooves or openings 625a and 625b may be defined in the front (first) conductive layers 620 of the corresponding photovoltaic cells, as shown in FIG. 6B. The additional grooves or openings 625a and 625b can be defined by the first laser scribing or mechanical needle scribing P1, as disclosed above and shown in FIG. 5B. The additional groove or opening 625a is filled with the material of an active layer 630.

As shown in FIG. 6C, the two sub-modules 601 and 602 are arranged such that the front conductive layer of the sub-module 601 is spatially separated from the front conductive layer of the sub-module 602 by two grooves or openings 625a and 625b; the active layer of the sub-module 601 is spatially separated from the active layer of the sub-module 602 by a space 635a; while the back conductive layer of the sub-module 601 and the back conductive layer of the sub-module 602 are integrally formed. Similarly, the grooves or openings 625a and 625b can be defined by the first laser scribing or mechanical needle scribing P1, as disclosed above and shown in FIG. 5B, while the space 635a can be defined by the second laser scribing or mechanical needle scribing P2, as disclosed above and shown in FIG. 5D.

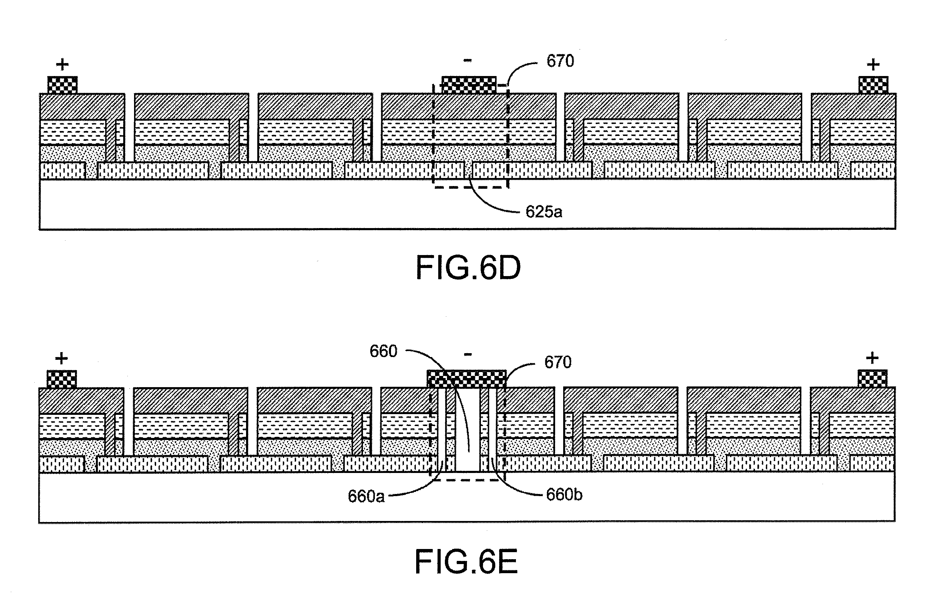

In the example shown in FIG. 6D, only is the front conductive layer of the sub-module 601 spatially separated from the front conductive layer of the sub-module 602 by a groove 625a. The other layers of the sub-module 601 and the corresponding layers of the sub-module 602 are integrally formed.

In the exemplary embodiment shown in FIG. 6E, the two adjacent sub-modules 601 and 602 are completely separated by three spaces or gaps 660 and 660a and 660b, which, for example, are defined by the first and third laser scribing (P1 and P3) or mechanical needle, as disclosed above and shown in FIG. 5F.

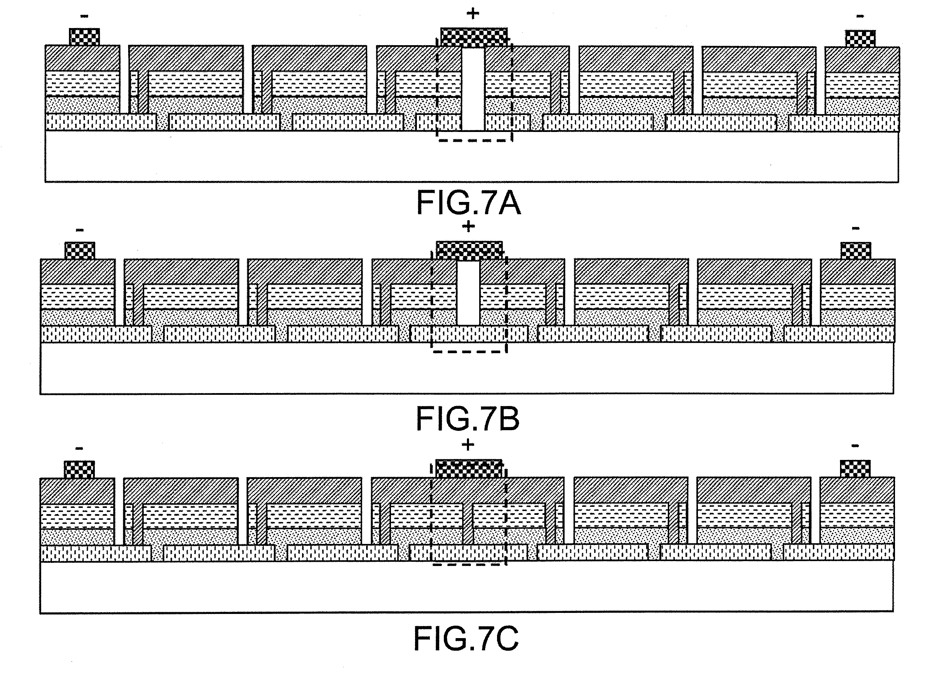

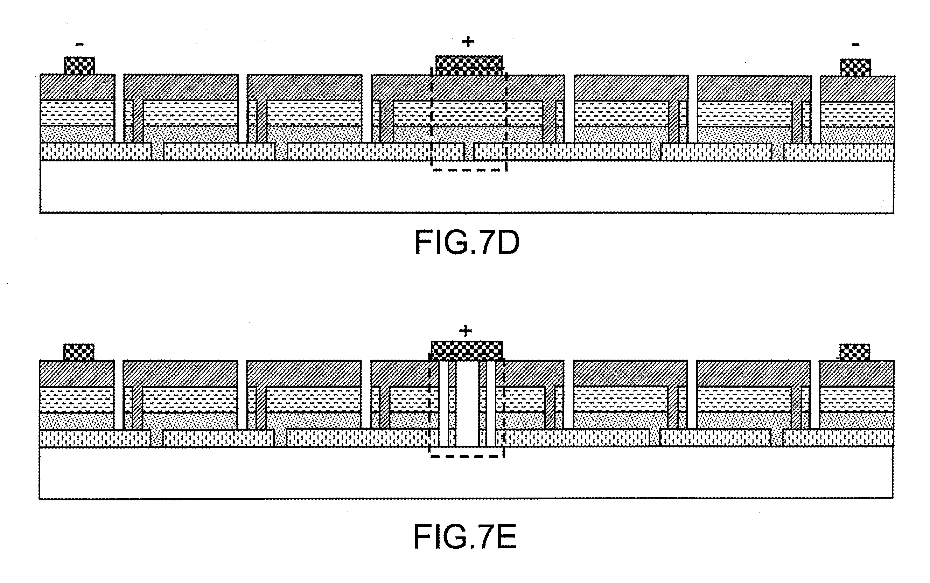

FIGS. 7A-7E show various connection configurations between two adjacent sub-modules that are similar to that shown in FIGS 6A-6E, except that the pair of adjacent electrodes formed on the two adjacent sub-modules has the same positive polarity, indicated by "+".

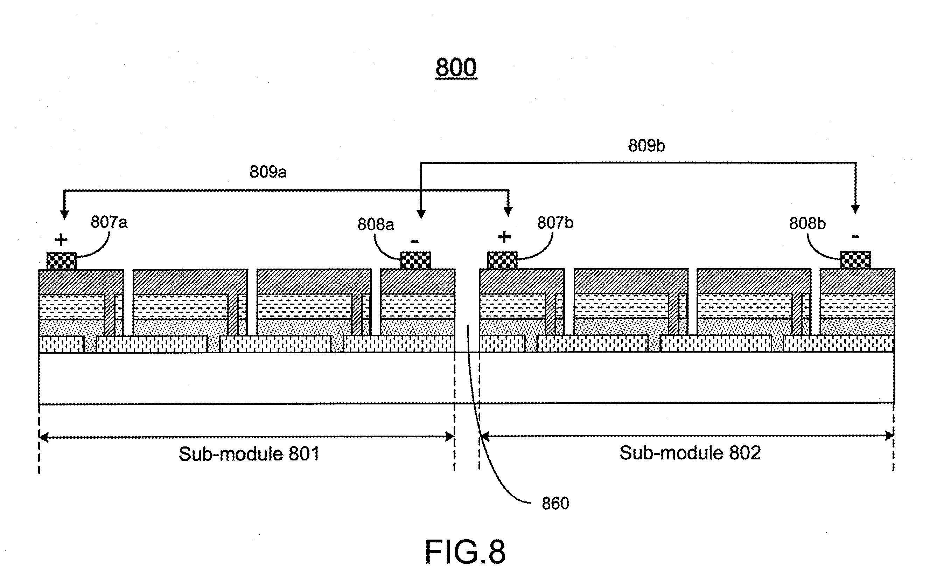

Referring to FIG. 8, a photovoltaic module 800 is schematically shown according to one embodiment of the present invention. The photovoltaic module 800 has two sub-modules 801 and 802 spatially separated by a space or gap 860, and arranged such that the adjacent electrodes 808a and 807b positioned at each side of the gap 860 have different polarities, indicated by "-" and "+", respectively. The positive electrode 807a of the sub-modules 801 is electrically connected to the positive electrode 807b of the sub-modules 802, for example, by a conductive lead 809a. The negative electrode 808a of the sub-modules 801 is electrically connected to the negative electrode 808b of the sub-modules 802, for example, by a conductive lead 809b.

One aspect of the present invention also provides a photovoltaic module having a plurality of sub-modules formed on a substrate. Each sub-module includes a plurality of photovoltaic cells spatially arranged as an array, each cell having first and second conductive layers sandwiching an active layer therebewteen. The cells in each sub-module are electrically connected to each other in series. Each sub-module further includes positive and negative electrodes formed on the second conductive layers of the first and last cells, respectively, in a respective sub-module. The positive electrode of each sub-module is electrically connected to each other and the negative electrode of each sub-module is electrically connected to each other such that the plurality of sub-modules is electrically connected in parallel. In one embodiment, the positive electrode of each sub-module is electrically connected to each other by a first conductive ribbon, and wherein the negative electrode of each sub-module is electrically connected to each other by a second conductive ribbon.

The plurality of sub-modules is spatially arranged next to each other as an array in the same direction as the array of the plurality of cells in each sub-module.

In one embodiment, at least one sub-module and its immediately next sub-module are configured such that the at least one sub-module is separated from its immediately next sub-module by a gap. In one embodiment, the pair of adjacent electrodes positioned at each side of the gap has the same polarity, and is electrically connected to each other via a conductive member formed in and/or across over the gap. The conductive member is formed of a material that has an electrical conductivity that is not lower than that of the corresponding second conductive layer positioned at each side of the gap.

In another embodiment, at least one sub-module and its immediately next sub-module are configured such that at least one layer of the at least one sub-module is spatially separated from a corresponding layer of its immediately next sub-module.

In brief, the present invention, among other things, recites a photovoltaic module having a plurality of sub-modules spatially arranged next to each other such that at least one sub-module is separated from its immediately next sub-module by a gap and each pair of adjacent electrodes formed on two adjacent sub-modules has the same polarity. Such a photovoltaic module can have a low operation voltage that is comparable to that of a bulk silicon photovoltaic module of the same size. Comparing with a conventional thin film solar module, the invented photovoltaic module has advantages in installation.

The foregoing description of the exemplary embodiments of the invention has been presented only for the purposes of illustration and description and is not intended to be exhaustive or to limit the invention to the precise forms disclosed. Many modifications and variations are possible in light of the above teaching.

The embodiments were chosen and described in order to explain the principles of the invention and their practical application so as to activate others skilled in the art to utilize the invention and various embodiments and with various modifications as are suited to the particular use contemplated. Alternative embodiments will become apparent to those skilled in the art to which the present invention pertains without departing from its spirit and scope. Accordingly, the scope of the present invention is defined by the appended claims rather than the foregoing description and the exemplary embodiments described therein.

## Claims

1. A photovoltaic module formed on a substrate, comprising:
a plurality of sub-modules, each sub-module comprising a plurality of photovoltaic cells spatially arranged as an array, each photovoltaic cell comprising a first conductive layer formed on the substrate, an active layer formed on the first conductive layer, and a second conductive layer formed on the active layer,
wherein the plurality of photovoltaic cells in each sub-module is electrically connected to each other in series such that the second conductive layer in any one but the last cell in a respective sub-module is electrically connected to the first conductive layer of the immediate next cell in the respective sub-module;
wherein each sub-module further comprises a positive electrode and a negative electrode formed on the second conductive layer of the first cell and on the second conductive layer of the last cell, respectively, in a respective sub-module; and
wherein the plurality of sub-modules are spatially arranged next to each other as an array in the same direction as the array of the plurality of cells in each sub-module such that each two adjacent sub-modules are separated by a gap therebetween such that a corresponding pair of adjacent electrodes positioned at each side of a gap has the same polarity and is electrically connected to each other via a conductive member disposed in or across over the gap that separates the corresponding pair of adjacent sub-modules.

2. The photovoltaic module of claim 1, wherein the gap has a width ranging from about 0.1 µm to about 1500 µm.

3. The photovoltaic module of claim 1, wherein the conductive member and the pair of adjacent electrodes are integrally formed.

4. The photovoltaic module of claim 1, wherein the conductive member is formed of a material that has an electrical conductivity that is not lower than that of the corresponding second conductive layers positioned at each side of the gap.

5. The photovoltaic module of claim 1, wherein each of the first conductive layer and the second conductive layer comprises a transparent conducting oxide (TCO) or a metal.

6. The photovoltaic module of claim 5, wherein the TCO comprises zinc oxide (ZnO), tin oxide (SnO₂) indium tin oxide (ITO), aluminum tin oxide (ATO), aluminum zinc oxide (AZO), cadmium indium oxide (CIO), cadmium zinc oxide (CZO), gallium zinc oxide (GZO), fluorine tin oxide (FTO), or a combination of them.

7. The photovoltaic module of claim 5, wherein the metal comprises molybdenum (Mo), titanium (Ti), nickel (Ni), aluminum (Al), gold (Au), silver (Ag), chromium (Cr), copper (Cu) or a combination of them.

8. The photovoltaic module of claim 1, wherein the active layer comprises one or more light absorption layers formed of one or more semiconductors.

9. The photovoltaic module of claim 1, wherein the positive electrode of each sub-module is electrically connected to each other, and wherein the negative electrode of each sub-module is electrically connected to each other, such that the plurality of sub-modules is electrically connected in parallel.

10. The photovoltaic module of claim 9, wherein the positive electrode of each sub-module is electrically connected to each other by a first conductive ribbon, and wherein the negative electrode of each sub-module is electrically connected to each other by a second conductive ribbon.

11. The photovoltaic module of claim 1, wherein at least one sub-module and its immediately next sub-module are configured such that at least one layer of the at least one sub-module is spatially separated from a corresponding layer of its immediately next sub-module.
